# FASCICULE DE BREVET EUROPEEN

(11) **EP 1 954 851 B1**
(45) Date de publication et mention de la délivrance du brevet: **22.02.2017**
(21) Numéro de dépôt: 06819678.1
(22) Date de dépôt: 22.11.2006
(51) Int. Cl.: C23C 16/448, C23C 16/455

(54) **INSTALLATION D'ALIMENTATION EN GAZ POUR MACHINES DE DEPOT D'UNE COUCHE BARRIERE SUR RECIPIENTS**
GASZUFUHRINSTALLATION FÜR MASCHINEN, DIE AUF BEHÄLTERN EINE BARRIERESCHICHT ABSCHEIDEN
GAS FEED INSTALLATION FOR MACHINES DEPOSITING A BARRIER LAYER ON CONTAINERS

(30) Priorité: 01.12.2005 FR 0553671
(43) Date de publication de la demande: 13.08.2008
(73) Titulaire: Sidel Participations, 76930 Octeville Sur Mer (FR)
(72) Inventeur: RIUS, Jean-Michel, F-76930 Octeville sur Mer (FR)
(74) Mandataire: Grassin d'Alphonse, Emmanuel Jean Marie
(86) Numéro de dépôt international: PCT/EP2006/068773
(87) Numéro de publication internationale: WO 2007/063015

(56) Documents cités:
- US-A- 5 462 899
- US-A- 5 827 571
- US-B1- 6 758 591

## Description

La présente invention concerne une installation pour fournir un précurseur gazeux utilisé afin de réaliser une couche barrière dans une machine de dépôt de couches barrière pour récipients, en particulier des bouteilles.

Dans l'état de la technique, on a déjà décrit des machines de dépôt de couches barrières qui comportent au moins un poste de traitement avec une enceinte à vide dans laquelle les récipients à revêtir d'une couche barrière sont introduits. A l'aide d'une installation d'alimentation en gaz, un précurseur gazeux (sous forme de gaz simple ou de mélange de gaz) est introduit à l'intérieur du récipient dans lequel le vide a été réalisé et un plasma du précurseur est généré en utilisant une énergie micro-ondes appliquée à l'aide d'un amorceur.

La formation du plasma à l'intérieur du récipient provoque l'apparition d'une couche barrière sur la paroi interne du récipient, laquelle couche permet notamment de protéger le produit de remplissage, introduit ultérieurement dans le récipient, des agressions extérieures et de rendre le récipient plus imperméable aux gaz.

On pourra se reporter aux publications du demandeur comme FR-A-2.783.667 ou FR-A-2.791 .598.

Cependant, les machines de dépôt de couches barrière sur récipients sont utilisées à des cadences de production très élevées. En conséquence, le temps d'établissement de la pression gazeuse nécessaire à l'amorçage du plasma dans le récipient doit être extrêmement bref.

Les solutions de l'état de la technique ne sont pas satisfaisantes dès lors que la cadence de production dépasse un seuil déterminé.

Dans l'état de la technique, on a déjà décrit l'utilisation d'un mélange gazeux pour réaliser le plasma. On a aussi décrit des procédés impliquant l'application de deux couches successives :
- une couche d'accrochage à la paroi intérieure du récipient,
- une couche barrière proprement dite.

L'installation d'alimentation en gaz de la machine comporte, en association avec chaque poste de traitement d'un récipient, un injecteur qui est agencé pour déboucher dans le récipient à traiter de façon à remplir le volume intérieur de ce récipient du mélange gazeux (précurseur) approprié. Certains composants du mélange gazeux peuvent être stockés sous forme gazeuse et d'autres peuvent être stockés sous phase liquide en amont de l'installation d'alimentation en gaz de la machine.

Dans le cas, d'une alimentation toute en gaz, on s'est aperçu que la durée d'injection de gaz afin d'assurer l'apport d'un volume suffisant de gaz dans le récipient après que le vide initial y a été réalisé ne pouvait pas être réduite en dessous d'un certain seuil, ce qui est préjudiciable à la cadence globale de traitement de l'installation.

Le phénomène se trouve amplifié lorsque le précurseur ou certains de ses composants, dans le cas d'un mélange, sont stockés en amont de l'installation d'alimentation en gaz, en phase liquide : en effet, dans ce cas, il faut préalablement réaliser un changement de phase du précurseur, consistant en un passage de sa phase liquide en sa phase gazeuse, après que le vide a été établi dans le récipient et que la ligne d'alimentation en précurseur est mise en communication avec l'intérieur du récipient.

Le document US-A-5.827.571 divulgue une installation d'alimentation en gaz pour machine de dépôt de couches qui comporte une tête de mixage des gaz, des moyens de mise en régime des gaz et un injecteur. Cependant, la tête de mixage, les moyens de mise en régime et l'injecteur sont agencés en série. Une telle disposition ne permet pas de maîtriser les conditions de fonctionnement des différents composants entre deux opérations de dépôts de couche.

Le document US-A-5.462.899 ne divulgue aucun moyen de mise en régime des gaz. Il ne divulgue donc pas les moyens permettant de maîtriser les conditions de fonctionnement des différents composants entre deux opérations de dépôts de couche.

La présente invention a pour but de s'affranchir de ces limitations de l'état de la technique.

A cet effet, la présente invention concerne une installation d'alimentation en gaz pour machine de dépôt de couches barrière sur la paroi interne de récipients par plasma froid, caractérisée en ce qu'elle comporte :
- au moins une première partie comportant une cuve remplie d'un composant liquide, laquelle cuve est régulée en température et en pression pour vaporiser le composant liquide afin de le faire passer en phase gazeuse, laquelle première partie est raccordée par au moins une ligne de gaz au reste de l'installation ;
- au moins une seconde partie comportantun dispositif de répartition qui comporte au moins une tête de mixage connectée en amont aux lignes de gaz qui lui correspondent par l'intermédiaire d'électrovannes et connectée en aval par une électrovanne commandée à au moins un injecteurdestiné à être inséré dans un récipient à traiter, lorsque celui-ci est disposé dans une enceinte à vide ;
- un moyen de mise en régime qui coopère avec le dispositif de répartition pour injecter au moins un mélange gazeux, et qui est relié à l'injecteur, chaque tête de mixage est connectée au moyen de mise en régime directement par une électrovanne respective en parallèle par rapport à l'injecteur.

Selon un autre aspect de l'invention, le débit de chaque ligne de gaz connectée à la cuve est contrôlé par un débitmètre respectif, par exemple du type débitmètre massique, et les sorties aval des débitmètres sont court-circuitées sur commande à l'aide d'électrovannes, pour mettre rapidement le réservoir à la pression d'utilisation.

Selon un autre aspect de l'invention, les électrovannes pour court-circuiter les sorties des lignes de gaz sont aussi connectées à la cuve par une électrovanne commandable, pour mettre rapidement le réservoir à la pression d'utilisation.

Selon un autre aspect de l'invention, l'installation comporte des capteurs d'état de l'utilisation d'alimentation et un premier contrôleur qui comporte un moyen de saisie d'informations d'au moins l'un desdits capteurs d'état de l'utilisation d'alimentation et le contrôleur comporte un moyen pour exécuter un programme de contrôle préenregistré sur la base des informations saisies et un moyen pour produire en réponse des signaux de commande pour régler :
- la valeur d'ouverture des débitmètres et/ou ;
- la valeur d'ouverture des vannes de mise en régime, de by-pass et/ou de remplissage et/ou ;
- l'énergie de réchauffement sur l'élément chauffant.

Selon un autre aspect de l'invention, l'installation comporte au moins les capteurs suivants d'état de l'utilisation d'alimentation :
- une sonde de mesure du niveau liquide dans la cuve ;
- un capteur de pression de mesure de pression de gaz dans la cuve ;
- un thermocouple de mesure de température d'au moins l'un des débitmètres en vue de réguler la température du fluide y circulant;
- un thermocouple de mesure de température dans la cuve en vue de réguler la température à l'intérieur de celle-ci;
- un thermocouple de mesure de la température dans la partie liquide de la cuve en vue de réguler la température de la partie liquide dans la cuve.

Selon une autre caractéristique, chaque débitmètre est associé à un thermocouple de régulation de sa température respective afin de réguler la température du fluide circulant dans chacun des débitmètres.

Selon un autre aspect de l'invention, le moyen de mise en régime comporte une nourrice comportant un raccord qui est connecté à une pompe à vide.

Selon un autre aspect de l'invention, le moyen de mise en régime est raccordé aux moyens de mélange par des électrovannes commandables.

Selon un autre aspect de l'invention, au moins une tête de mixage est connectée à une chambre de compensation.

Selon un autre aspect de l'invention, les électrovannes commandables disposées en sortie de chaque tête de mixage sont commandées en opposition.

Selon un autre aspect de l'invention, chaque paire d'électrovannes associées à la sortie d'une tête de mixage est constituée par une électrovanne tiroir à deux entrées et deux sorties.

Selon un autre aspect de l'invention, l'installation comporte un second contrôleur, encore appelé contrôleur de seconde partie, qui comporte un moyen de saisie d'informations, qui reçoit les signaux d'une pluralité de capteurs, parmi lesquels :
- au moins un capteur de pression et/ou au moins un capteur de débit, et/ou
- des capteurs de signaux d'état d'au moins une des électrovannes et des têtes de mixage ainsi que du capteur de pression pour le contrôle du niveau de vide sur le récipient en cours de traitement ;
- le second contrôleur comporte par ailleurs un moyen de calcul qui exécute un programme de réglage préenregistré et un moyen de réglage commandé par le moyen de calcul qui applique enfin des signaux de commande de valeur d'ouverture d'au moins l'une des électrovannes pour l'application d'au moins une première et/ou une seconde couches.

Selon un autre aspect de l'invention, le second contrôleur exécute un programme de commande de l'installation selon deux modes successifs respectivement, un mode de démarrage ou d'attente dans lequel les moyens de mélange sont connectés au moyen de mise en régime puis un mode de dépôt de couches, dans lequel, séquentiellement le moyen de mélange pour chaque couche à déposer sur le récipient à traiter est successivement connecté à la chambre de compensation.

D'autres caractéristiques et avantages de l'invention apparaîtront à l'aide de la description et des figures annexées parmi lesquelles :
- la figure 1 représente une première partie de l'installation d'alimentation pour générer au moins un gaz précurseur ;
- la figure 2 illustre une seconde partie de l'installation de l'alimentation permettant la mise en pression d'au moins un récipient lors de la phase d'injection d'au moins un mélange gazeux.

Dans la suite de la description, on va exposer les principes de l'invention dans le cadre d'un exemple de réalisation d'une installation d'alimentation en gaz pour une machine de dépôt de deux couches successives, chaque couche étant obtenue à partir d'un mélange gazeux particulier.

La première couche de dépôt utilise un premier composant qui est présent sous forme d'un précurseur liquide à base de silane, comme du HMDS ou du TDMS, et un second composant présent sous la forme gazeuse comme de l'oxygène ou de l'azote.

La seconde couche de dépôt, réalisée après la première couche, utilise le même premier composant, à savoir un silane comme du HMDS ou du TDMS, et un second composant présent sous forme gazeuse comme de l'oxygène.

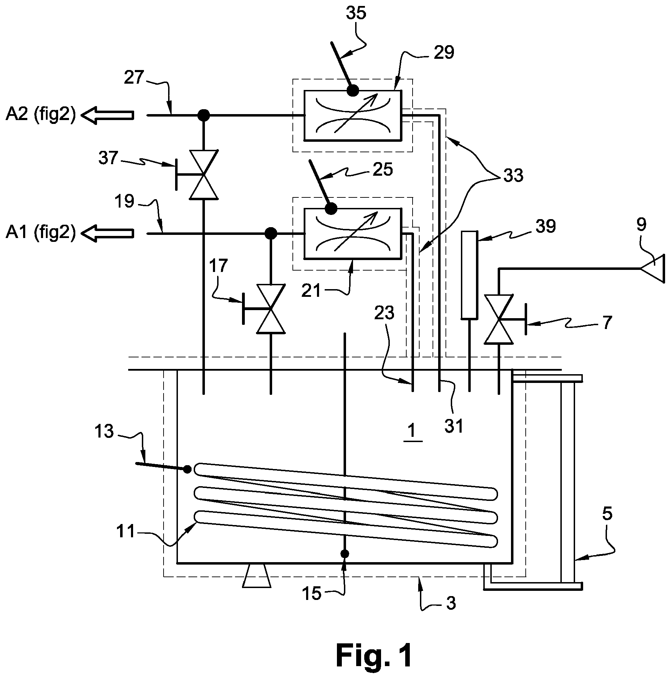

Sur la figure 1, on a illustré une partie d'une machine de dépôt d'une couche barrière agencée conformément à l'invention qui consiste en une installation permettant la préparation d'un composant gazeux à partir d'un précurseur qui est stocké en amont de l'installation d'alimentation sous forme liquide.

La préparation des seconds composants sous forme de précurseurs gazeux ne présente pas de difficultés particulières.

Il convient de noter que, si le procédé de dépôt nécessite l'emploi de plus d'un composant qui serait stocké en amont de l'installation d'alimentation sous forme liquide, alors la machine comporterait un nombre correspondant d'installations, identiques ou similaires à celle représentée sur la figure 1.

Une installation de préparation du gaz à partir d'un précurseur stocké sous forme liquide comporte une première partie constituée par une cuve 1, régulée en température et en pression afin d'obtenir la phase vapeur du précurseur.

La cuve 1 est disposée à proximité de la machine pour le dépôt de couches barrière sur un récipient, laquelle machine sera décrite plus loin.

La cuve 1 est équipée d'un dispositif de calorifugeage 3 ainsi que d'un capteur 5 de mesure du niveau, tel qu'une sonde ou autre moyen connu en soi, permettant de contrôler son niveau de remplissage et d'une vanne de remplissage 7 qui est connectée avec une arrivée 9 du liquide servant de précurseur au premier composant permettant de réaliser une couche barrière.

La cuve 1 de précurseur est aussi équipée d'un élément chauffant 11 qui peut être réalisé sous la forme d'un élément chauffant externe, entourant la cuve 1, ou d'un serpentin interne dans lequel circule un fluide caloporteur chauffé en amont. Un thermocouple 13 de mesure est prévu pour réguler la température de la cuve.

Un thermocouple 15 de sécurité de même qu'un capteur 39 de mesure de pression, par exemple de type piézo-électrique, sont disposés en relation avec l'intérieur de la cuve.

L'intérieur de la cuve communique par ailleurs avec une tubulure 19 d'alimentation d'une ligne A1 de gaz par l'intermédiaire d'une vanne de mise en régime 17 commandable, constituée par exemple par une électrovanne, dont l'entrée est connectée à la cuve et dont la sortie est reliée à la dite tubulure 19 alimentant la ligne A1 de gaz.

La tubulure 19 est par ailleurs reliée à la cuve 1 par un circuit en parallèle à travers un débitmètre 21 régulateur, par exemple du type débitmètre massique, dont l'entrée est directement connectée à l'intérieur de la cuve par un tube 23 et dont la sortie est connectée à la ligne A1 de gaz, c'est-à-dire en parallèle sur la sortie de fluide de ladite vanne de mise en régime 17.

Un thermocouple 25 de régulation est associé au débitmètre 21. Il sert à la régulation de la température du fluide passant à l'intérieur, température qui constitue un paramètre d'entrée d'un programme de contrôle de l'installation de gaz qui applique une règle de contrôle sur les éléments contrôlables comme les éléments chauffant 11 ou la vanne de remplissage 7 pour éviter toute condensation dans la ligne A1 de gaz Le programme de contrôle est enregistré et exécuté sur un premier contrôleur, encore nommé contrôleur de première partie et qui sera expliqué plus loin.

La vanne de mise en régime 17 constitue une vanne de "by-pass", qui a pour fonction de faciliter la mise en pression (niveau de vide) du circuit au début du cycle de fonctionnement, alors qu'en fonctionnement établi, c'est par l'intermédiaire du débitmètre 21 régulateur que le débit de gaz est contrôlé.

Dans le mode de réalisation illustré sur la figure 1, une seconde ligne A2 de gaz, identique à la ligne A1 de gaz, est connectée à la cuve de la même manière que celle-ci, c'est-à-dire par l'intermédiaire d'une vanne de mise en régime 37 commandable, telle qu'une électrovanne, dont l'entrée de fluide est connectée à la cuve et la sortie de fluide est reliée à une tubulure 27 alimentant la ligne A2 de gaz.

Par ailleurs, de manière similaire à la tubulure 19 d'alimentation de la ligne A1 de gaz, la tubulure 27 alimentant la ligne A2 de gaz est reliée à la cuve 1 en parallèle à travers un débitmètre 29 régulateur dont l'entrée est directement connectée à l'intérieur de la cuve par un tube 31 et dont la sortie est connectée à la ligne A2 de gaz, c'est-à-dire en parallèle sur la sortie de ladite vanne de mise en régime 37.

Il convient de noter que la ligne A2 de gaz peut être présente par exemple lors de la mise en oeuvre de procédés de traitement d'un récipient nécessitant deux injections séparées d'un même gaz à des débits identiques ou différents (par exemple deux injections séparées de HMDS ou de TMDS), ou encore lorsqu'il s'agit d'injecter le même gaz dans deux récipients différents, à des moments se chevauchant ou se superposant.

En conséquence, il convient de noter que la ligne A2 de gaz n'est pas nécessaire si un même gaz ne doit pas être injecté au même moment dans des récipients différents ou s'il n'est pas nécessaire de pratiquer des injections séparées d'un même gaz dans un même récipient.

En corollaire, il peut être nécessaire d'augmenter le nombre de lignes, si plus de deux injections d'un même gaz doivent avoir lieu dans un même récipient à des débits identiques ou différents ou encore s'il faut injecter le même gaz dans plus de deux récipients différents, à des moments se chevauchant ou se superposant.

La température du fluide circulant dans le débitmètre 29 régulateur de la ligne A2 de gaz est contrôlée à l'aide d'un thermocouple 35 de régulation analogue au thermocouple 25 de régulation expliqué en relation avec la ligne A1 de gaz c'est-à-dire dont la mesure constitue un paramètre d'entrée d'un programme de contrôle de l'installation de gaz qui applique une règle de contrôle sur les éléments contrôlables comme l'élément chauffant 11 ou la vanne de remplissage 7 pour éviter toute condensation dans la ligne A2 de gaz. Le programme de contrôle est enregistré et exécuté sur le premier contrôleur susmentionné qui est décrit ci-après.

Les tubes 23 et 31, ainsi que les débitmètres 21 et 29, sont protégés des échanges thermiques par des moyens de calorifugeage 33.

Le premier contrôleur, non représenté, auquel la première partie de l'installation est connectée, comporte un moyen de saisie ou d'entrée de données qui reçoit les informations d'au moins l'un des capteurs susmentionnés d'état de l'alimentation, à savoir :
- le capteur 5 de mesure du niveau de liquide dans la cuve 1 ;
- le capteur 39 de mesure de pression, pour la mesure de pression de gaz dans la cuve 1 ;
- le thermocouple 35 et/ou le thermocouple 25 de régulation de température de chacun des débitmètres 29 et/ou 21 ;
- le thermocouple 13 de mesure de température dans la cuve 1 ;
- d'un thermocouple 15 de sécurité de la température dans la partie liquide de la cuve 1.

Le contrôleur comporte un moyen de calcul tel qu'un microprocesseur qui reçoit les divers signaux précités et exécute un programme de contrôle préenregistré. Le contrôleur comporte enfin un moyen de réglage pour produire des signaux de commande pour régler :
- la valeur d'ouverture de chacun des débitmètres 21 et/ou 29 présents dans la première partie de l'installation,
- la valeur d'ouverture chacune des vannes de mise en régime 17, 37 présentes et/ou de la vanne de remplissage 7,
- l'énergie appliquée à l'élément chauffant 11.

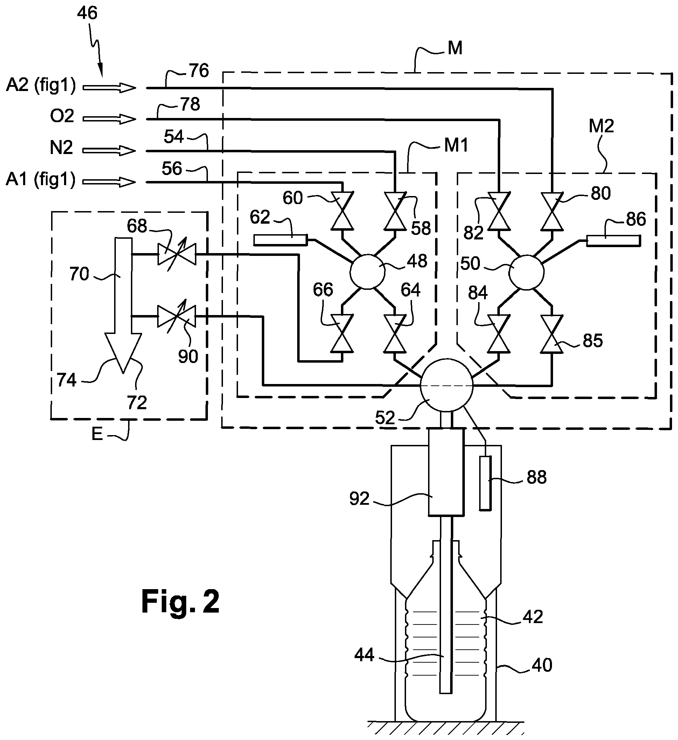

A la figure 2, on a illustré un mode de réalisation d'un agencement permettant d'injecter deux mélanges différents de deux gaz chacun au niveau de chaque poste de traitement d'une machine de dépôt de couches barrière pour des récipients, lequel agencement peut être connecté à une ou plusieurs installations conformes à celle de la figure 1, selon qu'il convient d'injecter un ou plusieurs gaz élaborés à partir de précurseur(s) liquide(s)..

L'agencement comporte une enceinte 40 pour recevoir un récipient 42 comme une bouteille, qui a été schématiquement représentée à la figure 2.

Le récipient 42 à l'intérieur duquel on veut réaliser le dépôt d'une couche barrière est maintenu dans l'enceinte qui comporte des moyens, connus en soi pour y maintenir le vide (non représentés).

Un injecteur 44 débouche dans l'enceinte 40, et est prévu pour être inséré dans le récipient 42, par l'ouverture du goulot dans le cas d'un récipient 42 en forme de bouteille. L'injecteur 44 est alimenté en gaz par un dispositif de répartition M qui sera détaillé plus loin et qui est lui-même alimenté par une pluralité de lignes, ici quatre lignes 54, 56, 76, 78, d'alimentation en gaz, lesquels gaz parviennent au dispositif de répartition dans le sens illustré par les flèches 46.

Comme on le lira plus loin, une ou plusieurs des lignes 54, 56, 76, 78, peuvent être connectées à une installation du type de celle de la figure 1.

Le mode de réalisation de la figure 2 illustre un agencement qui permet de réaliser successivement, à partir de deux mélanges de deux gaz différents chacun, deux couches intérieures superposées, la première couche intérieure servant de couche d'accrochage pour la seconde couche qui sert de couche barrière proprement dite, ou bien encore, la première couche intérieure servant de couche barrière, et la seconde couche constituant une couche de protection pour la première.

A cet effet, le dispositif de répartition M comporte un ensemble de deux moyens de mélange M1, M2, comprenant chacun une tête de mixage, respectivement 48, 50. Un premier M1 des moyens de mélange réalise le mélange des deux gaz nécessaires à l'une des couches, l'autre M2, réalisant le mélange des deux gaz nécessaires à l'autre couche.

Dans l'exemple illustré, on suppose que le premier moyen de mélange M1 permet de mélanger de l'azote (N2) apporté par une ligne de gaz 54 avec un gaz à base de silane, obtenu à partir d'un précurseur liquide, et mis à l'état gazeux à l'aide d'une installation conforme à celle de la figure 1. On considère que ce gaz à base silane est apporté par une ligne de gaz 56 connectée à la ligne A1 de gaz de l'installation de la figure 1.

On suppose encore que le second moyen de mélange M2 permet de mélanger de l'oxygène (02) apporté par une ligne de gaz 78 avec un gaz à base de silane, obtenu à partir d'un précurseur liquide, et mis à l'état gazeux à l'aide d'une installation conforme à celle de la figure 1. On considère que ce gaz à base silane est ici apporté par une ligne de gaz 76 connectée à la ligne A2 de gaz de l'installation de la figure 1.

Il est bien entendu que si au lieu d'un gaz à base de silane, ou bien encore d'oxygène ou d'azote, un autre gaz obtenu à partir d'un précurseur liquide était apporté par l'une ou l'autre des lignes de gaz 54, 56, 76, 78, alors une ou plusieurs autres installations conformes à celle de la figure 1 seraient utilisées.

La ligne de gaz 54 est connectée à la tête de mixage 48 du premier moyen de mélange M1 par une électrovanne 58 et, parallèlement, la ligne de gaz 56 est connectée à la même tête de mixage 48 par une électrovanne 60.

Par ailleurs, la tête de mixage 48 est aussi connectée, d'une part, par l'intermédiaire d'une première électrovanne 64, à une chambre de compensation 52 de changement de ligne et, d'autre part, par l'intermédiaire d'une électrovanne 66 elle-même couplée à une vanne 68 d'équilibrage de débit, à une nourrice 70 de mise en régime des gaz.

Un capteur 62 de débit pour la régulation de la vanne 68 d'équilibrage des débits est disposé en relation avec la tête de mixage 48.

La nourrice 70 de mise en régime des gaz est raccordée à une pompe à vide (non représentée) de mise en régime des gaz au moyen d'un raccord 72 de type DIN 40, par exemple.

Le second moyen de mélange M2 pour le dépôt d'une seconde couche est similaire au premier moyen de mélange M1. Ainsi, la ligne de gaz 76 est connectée à la tête de mixage 50 du second moyen de mélange M2 par une électrovanne 80, tandis que la ligne de gaz 78 d'amenée d'oxygène est connectée à la même tête de mixage 50 par une électrovanne 82.

La tête de mixage 50 est couplée, d'une part, par l'intermédiaire d'une première électrovanne 84 à la chambre de compensation 52 de changement de ligne, et, d'autre part, par l'intermédiaire d'une électrovanne 85 elle-même couplée à une vanne 90 d'équilibrage de débit, à la nourrice 70 de mise en régime des gaz.

Un capteur 86 de débit pour la régulation de la vanne 90 d'équilibrage des débits est disposé en relation avec la tête de mixage 50.

Un capteur de pression 88 est disposé en relation avec l'intérieur du récipient 42 de façon à contrôler l'état du vide avant le début de l'application de dépôt de la première couche et/ou de la seconde couche.

On parvient ainsi à optimiser le processus de production de gaz dans l'installation de l'invention.

Un contrôleur permet de régler le fonctionnement de la seconde partie. Le contrôleur de seconde partie est, dans un mode de réalisation, une section du contrôleur de première partie déjà décrit pour le contrôle de la première partie représentée à la figure 1. Dans un autre mode de réalisation, le contrôleur de seconde partie est une unité autonome. D'une manière générale, le contrôleur de seconde partie comporte un moyen de saisie ou d'entrée d'informations, qui reçoit les signaux d'une pluralité de capteurs, parmi lesquels peuvent se trouver
- les capteurs 62, 86, de débit et/ou le capteur de pression 88;
- des capteurs de signaux d'état d'au moins une des électrovannes 58, 60, 80, 82, 64, 66, 84, 85, 68, 90 et des têtes de mixage 48, 50, ainsi que du capteur de pression 88 pour le contrôle du niveau de vide sur le récipient 42 en cours de traitement.

En réponse, le contrôleur de seconde partie comporte un moyen de calcul qui exécute un programme de réglage préenregistré. Le contrôleur de seconde partie comporte enfin un moyen de réglage commandé par le moyen de calcul. Le moyen de réglage applique enfin des signaux de commande de valeur d'ouverture d'au moins l'une des électrovannes 58, 60, 80, 82, 64, 66, 84, 85 pour l'application de la première et/ou de la seconde couches.

Dans un mode particulier de réalisation, les vannes 68 et 90 d'équilibrage des débits reliées à la nourrice 70 de mise en régime des gaz sont des vannes dont la commande est manuelle pour réaliser l'équilibrage des débits lors d'une configuration de la machine de dépôt de couches barrière.

Dans un autre mode de réalisation, les vannes 68 et 90 d'équilibrage des débits reliées à la nourrice 70 sont des vannes dont la commande est exécutée à l'aide du contrôleur précité lors d'une phase d'étalonnage ou lors d'une phase de configuration de la machine de dépôt de couches barrière.

La chambre de compensation 52 de changement de ligne comporte un port d'accès 92 à un dispositif de fixation de l'injecteur 44 de gaz qui est connecté à l'injecteur du mélange gazeux à l'intérieur du récipient 42, par exemple une bouteille..

La seconde partie de l'installation de gaz de la présente invention, qui a été décrite ci-dessus à l'aide de la figure 2, comporte deux régimes de fonctionnement.

Dans un premier régime de fonctionnement, le contrôleur de l'installation de gaz commande l'alimentation des différents composants précités dans des conditions de démarrage ou d'attente dans lesquelles on réalise l'équilibrage des pressions et des débits des composants gazeux.

Afin d'obtenir les conditions optimales de fonctionnement, les composants sont aiguillés par les têtes de mixage 48, 50 et les électrovannes respectivement 66 et 85 vers la pompe à vide de mise en régime de mise en régime par le raccord 72.

Pour obtenir des conditions de pression et de débits constants dans la chambre de compensation 52, et donc pour obtenir ces conditions constantes à la sortie de l'injecteur 44, on règle l'ouverture des vannes 68 et 90.

Si les vannes 68 et 90 sont pilotées, la consigne de régulation est prise au niveau de l'une et/ou de l'autre des têtes de mixage 48 ou 50 à l'aide des capteurs de débit 62 ou 86, respectivement.

Dans les phases de dépôt, on réalise la composition du mélange par l'intermédiaire des électrovannes respectivement 64, pour réaliser la première couche, et électrovanne 84, pour réaliser la seconde couche qui dirigent les mélanges appropriés de gaz vers la chambre de compensation 52, puis, l'injecteur 44.

Le rôle de la chambre de compensation 52 est de permettre une transition sans perturbations du plasma lors du basculement de la phase de dépôt de la première couche, avec la phase de dépôt de la seconde couche.

Plusieurs variations sont possibles sur la base de l'enseignement de la description. Particulièrement, il est possible d'utiliser une vanne tiroir à deux positions pour remplacer les deux électrovannes 66 et 64 pilotées, puisque, en toutes circonstances, les deux électrovannes 66 et 64 travaillent alternativement, la première étant fermée quand la seconde est ouverte. La même variation est possible pour la paire de vannes 84 et 86 qui peut aussi être remplacée par une vanne tiroir à deux positions.

Selon le principe de l'invention, le contrôle du débit instantané sur chaque ligne de gaz est effectué en agissant sur la pression à l'aide des divers moyens de variation de pression de l'installation d'alimentation que sont les dites électrovannes, 66, 64, 84, 86 pilotées et, le cas échéant, les vannes 68 et 90.

Dans un mode particulier de réalisation, les électrovannes 58, 60, 82, 80 qui sont toujours ouvertes pendant le fonctionnement normal de l'installation de l'invention sont aussi contrôlées pour exécuter des procédures de sécurité et/ou des procédures de maintenance : elles constituent dans ce cas des électrovannes d'isolement.

Le contrôleur de l'installation d'alimentation de gaz selon l'invention, qui comporte un contrôleur de première partie et un contrôleur de seconde partie, pouvant être le cas échéant confondus, comporte un moyen de calcul exécutant un programme travaillant selon deux modes :
- un mode de démarrage ou d'attente ;
- un mode de dépôt de couches.

Dans le mode de démarrage ou d'attente, le moyen de calcul active un moyen pour produire des signaux de commande, principalement de commande de valeur d'ouverture des électrovannes des première et seconde parties, de sorte que soit réalisé un équilibrage des pressions et des débits sur les lignes de gaz connectées aux têtes de mixage. A cette fin, les électrovannes 66 et 85 de sortie des têtes de mixage respectivement 48 et 50 sont ouvertes de sorte que les pressions de toutes les lignes de gaz 76, 78, 54 et 56 soient tirées vers la pression de vide appliquée par le moyen de mise en régime E, constitué par le vannes 68, 90 et la nourrice 70.

Les électrovannes 64 et 85 de connexion à la chambre de compensation 52 et donc à l'injecteur 44 sont fermées.

Pour exécuter la régulation, le contrôleur de l'installation utilise principalement la mesure de la pression au niveau des têtes de mixage 48, 50.

Dans le mode de dépôt, le moyen de calcul active un moyen pour produire des signaux de commande, principalement de commande de valeur d'ouverture des électrovannes des première et seconde parties, de sorte que soit réalisé le dépôt d'abord d'une première couche (d'accrochage dans l'exemple illustré) par le moyen de mélange M1, puis d'une seconde couche (barrière proprement dite dans l'exemple illustré) par le moyen de mélange M2. A cette fin, l'électrovanne 64 est ouverte, tandis que l'électrovanne 66 est fermée. Dans le même temps, les autres têtes de mixage, la seule tête de mixage 50 dans l'exemple de la figure 2, restent connectées sur le moyen de mise en régime E. Une fois le dépôt de la couche d'accrochage exécuté, le moyen pour produire des signaux de commande commute les électrovannes commandables de sorte que le mélange pour la seconde couche soit exécuté sur la seconde tête de mixage 50. Pour que le mélange débite sur l'injecteur 44, l'électrovanne 85 est fermée pour isoler la seconde tête de mixage 50 des moyens de mise en régime et l'électrovanne 84 est ouverte pour la connecter à la chambre de compensation 52.

La chambre de compensation 52 permet d'éviter la perturbation du plasma établi dans le récipient 42 en cours de traitement pour exécuter la première, puis la seconde couche. La chambre de compensation 52 assure ainsi une transition du régime gazeux lors du basculement de la phase de dépôt de la couche d'accrochage à la phase de dépôt de la couche barrière proprement dite.

## Revendications

1. Installation d'alimentation en gaz pour machine de dépôt de couches barrière sur la paroi interne de récipients par plasma froid, **caractérisée en ce qu'**elle comporte :
- au moins une première partie comportant une cuve (1) remplie d'un composant liquide, laquelle cuve (1) est régulée en température et en pression pour vaporiser le composant liquide afin de le faire passer en phase gazeuse, laquelle première partie est raccordée par au moins une ligne de gaz au reste de l'installation ;
- au moins une seconde partie comportant un dispositif de
répartition (M) qui comporte au moins une tête de mixage (48, 50) connectée en amont aux lignes de gaz (54, 56, 76, 78) qui lui correspondent par l'intermédiaire d'électrovannes (58, 60, 80, 82) et connectée en aval par une électrovanne (64, 84) commandée à au moins un injecteur (44)destiné à être inséré dans un récipient (42) à traiter, lorsque celui-ci est disposé dans une enceinte (40) à vide ;
- un moyen de mise en régime (E) qui coopère avec le dispositif de répartition (M) pour injecter au moins un mélange gazeux, et qui est relié à l'injecteur (44),chaque tête de mixage (48, 50) est connectée au moyen de mise en régime (E) directement par une électrovanne (66, 85) respective en parallèle par rapport à l'injecteur (44).

2. Installation selon la revendication 1, **caractérisée en ce que** chaque ligne de gaz connectée à la cuve (1) est contrôlée par un débitmètre (21, 29) régulateur et **en ce que** les sorties aval des débitmètres (21, 29) sont court-circuitées sur commande à l'aide de vannes (17, 37) commandables, pour mettre rapidement le réservoir à la pression d'utilisation.

3. Installation selon la revendication 2, caractérisée en ce les électrovannes pour court-circuiter les sorties aval des débitmètres (21, 29) sont aussi connectées à la cuve (1) par une vanne de mise en régime (17) commandable, pour mettre rapidement le réservoir à la pression d'utilisation.

4. Installation selon l'une quelconque des revendications 1 à 3, **caractérisée en ce qu'**elle comporte des capteurs d'état de l'utilisation d'alimentation et un premier contrôleur qui comporte un moyen de saisie d'informations d'au moins l'un des capteurs d'état de l'utilisation d'alimentation et le contrôleur comporte un moyen pour exécuter un programme de contrôle préenregistré sur la base des informations saisies et un moyen pour produire en réponse des signaux de commande pour régler :
- la valeur d'ouverture des débitmètres (21) et (29),
- la valeur d'ouverture des vannes de mise en régime (17, 37) et/ou de vanne de remplissage (7),
- l'énergie de réchauffement sur l'élément chauffant (11).

5. Installation selon la revendication 4, caractérisée en ce les capteurs d'état de l'utilisation d'alimentation sont constitués au moins :
- d'un capteur (5) de mesure du niveau liquide dans la cuve (1) ;
- d'un capteur (39) de mesure de pression pour la mesure de pression de gaz dans la cuve (1) ;
- d'un thermocouple (25 ; 35) de régulation de température d'au moins l'un des débitmètres (21 ; 29) ;
- d'un thermocouple (13) de mesure de la température dans la cuve (1) ;
- d'un thermocouple (15) de sécurité de la température dans la partie liquide de la cuve (1).

6. Installation selon la revendication 5, **caractérisée en ce que** chaque débitmètre (21 ; 29) est associé à un thermocouple (25 ; 35) respectif de régulation de sa température.

7. Installation selon la revendication 1, **caractérisée en ce que** le moyen de mise en régime (E) comporte une nourrice (70) comprenant un raccord (72) qui est connecté à une pompe à vide.

8. Installation selon la revendication 7, **caractérisé en ce que** le moyen de mise en régime (E) est raccordé aux moyens de mélange (M) par des vannes (68, 90) d'équilibrage des débits commandables.

9. Installation selon l'une quelconque des revendications précédentes, **caractérisé en ce qu'**au moins une tête de mixage (48, 50) est connectée à une chambre de compensation (52).

10. Installation selon l'une quelconque des revendications 7 à 9, **caractérisé en ce que** les électrovannes (64, 66, 84, 85) commandables disposées en sortie de chaque tête de mixage (48, 50) sont commandées en opposition.

11. Installation selon la revendication 10, **caractérisé en ce que** chaque paire d'électrovannes associées à la sortie d'une tête de mixage est constituée par une électrovanne tiroir à deux entrées et deux sorties.

12. Installation selon l'une quelconque des revendications 4 à 11, **caractérisé en ce qu'**elle comporte un second contrôleur associé à la seconde partie et qui comporte un moyen de saisie d'informations, qui reçoit les signaux d'une pluralité de capteurs, parmi lesquels :
- au moins un capteur de débit (62, 86) et/ou un capteur de pression (88), et/ou
- des capteurs de signaux d'état d'au moins une des électrovannes (58, 60, 80, 82, 64, 66, 84, 85) et des vannes (68, 90) et des têtes de mixage (48, 50), ainsi que du capteur de pression (88) pour le contrôle du niveau de vide sur le récipient (42) en cours de traitement ;
- le second contrôleur comportant par ailleurs un moyen de calcul qui exécute un programme de réglage préenregistré et un moyen de réglage commandé par le moyen de calcul qui applique enfin des signaux de commande de valeur d'ouverture d'au moins l'une des électrovannes (58, 60, 80, 82, 64, 66, 84, 85) pour l'application d'au moins une première et/ou une seconde couches.

13. Installation selon la revendication 12, **caractérisé en ce que** le second contrôleur exécute un programme de commande de l'installation selon deux modes successifs respectivement, un mode de démarrage ou d'attente dans lequel les moyens de mélange (M1, M2) sont connectés au moyen de mise en régime (E) puis un mode de dépôt de couches, dans lequel, séquentiellement le moyen de mélange (M1, M2) pour chaque couche à déposer sur le récipient à traiter est successivement connecté à la chambre de compensation (52).

## Patentansprüche

1. Gaszufuhrinstallation für Maschinen, die eine Barriereschicht auf der Innenwand von Behältern durch kaltes Plasma abscheiden, **dadurch gekennzeichnet, dass** sie Folgendes umfasst:
- mindestens einen ersten Teil umfassend einen Behälter (1), der mit einer flüssigen Komponente gefüllt ist, wobei der Behälter (1) temperatur- und druckgeregelt ist, um die flüssige Komponente zu verdampfen, um sie in die Gasphase übergehen zu lassen, wobei der erste Teil durch mindestens eine Gasleitung mit dem Rest der Installation verbunden ist;
- mindestens einen zweiten Teil umfassend eine Verteilungsvorrichtung (M), die mindestens einen Mischkopf (48, 50) umfasst, der vorgelagert an die Gasleitungen (54, 56, 76, 78) angeschlossen ist, die ihm durch Magnetventile (58, 60, 80, 82) entsprechen, und nachgelagert durch ein gesteuertes Magnetventil (64, 84) an mindestens eine Einspritzdüse (44) angeschlossen ist, die dazu bestimmt ist, in ein zu behandelndes Gefäß (42) eingefügt zu werden, wenn dieses in einem Vakuumbehälter (40) angeordnet ist;
- ein Mittel zum Inbetriebsregimebringen (E), das mit der Verteilungsvorrichtung (M) zusammenwirkt, um mindestens ein Gasgemisch einzuspritzen, und das mit der Einspritzdüse (44) verbunden ist, wobei jeder Mischkopf (48, 50) an das Mittel zum Inbetriebsregimebringen (E) direkt durch ein jeweiliges Magnetventil (66, 85) parallel zu der Einspritzdüse (44) angeschlossen ist.

2. Installation nach Anspruch 1, **dadurch gekennzeichnet, dass** jede Gasleitung, die an den Behälter (1) angeschlossen ist, durch einen Durchflussmesser/-regler (21, 29) kontrolliert ist, und dass die nachgelagerten Ausgänge der Durchflussmesser (21, 29) mit Hilfe von steuerbaren Ventilen (17, 37) auf Befehl kurzgeschlossen werden, um den Behälter schnell auf den Betriebsdruck zu bringen.

3. Installation nach Anspruch 2, **dadurch gekennzeichnet, dass** die Magnetventile zum Kurzschließen der nachgelagerten Ausgänge der Durchflussmesser (21, 29) auch durch ein steuerbares Ventil zum Inbetriebsregimebringen (17) an den Behälter (1) angeschlossen sind, um den Behälter schnell auf den Betriebsdruck zu bringen.

4. Installation nach einem der Ansprüche 1 bis 3, **dadurch gekennzeichnet, dass** sie Zustandssensoren der Verwendung der Zufuhr und eine erste Steuerung aufweisen, die ein Mittel zum Erfassen von Informationen von mindestens einem der Zustandssensoren der Verwendung der Zufuhr aufweist, und die Steuerung ein Mittel, um ein vorgespeichertes Steuerungsprogramm auf der Grundlage der erfassten Information auszuführen und ein Mittel aufweist, um als Antwort Steuersignale zu erzeugen, um Folgendes einzustellen:
- den Öffnungswert der Durchflussmesser (21) und (29),
- den Öffnungswert der Ventile zum Inbetriebsregimebringen (17, 37) und/oder des Füllventils (7),
- die Erwärmungsenergie auf dem Heizelement (11) .

5. Installation nach Anspruch 4, **dadurch gekennzeichnet, dass** die Zustandssensoren der Verwendung der Zufuhr mindestens aus Folgendem gebildet sind:
- aus einem Messsensor (5) des Füllstands in dem Behälter (1) ;
- aus einem Sensor (39) für die Gasdruckmessung in dem Behälter (1);
- einem Thermoelement (25; 35) zur Temperaturregelung von mindestens einem der Durchflussmesser (21; 29);
- aus einem Thermoelement (13) zum Messen der Temperatur in dem Behälter (1);
- aus einem Sicherheitsthermoelement (15) der Temperatur in dem flüssigen Teil des Behälters (1) .

6. Installation nach Anspruch 5, **dadurch gekennzeichnet, dass** jeder Durchflussmesser (21; 29) einem jeweiligen Thermoelement (25; 35) zur Regelung seiner Temperatur zugeordnet ist.

7. Installation nach Anspruch 1, **dadurch gekennzeichnet, dass** das Mittel zum Inbetriebsregimebringen (E) einen Zuführungsbehälter (70) aufweist, der einen Anschluss (72) aufweist, der mit einer Vakuumpumpe verbunden ist.

8. Installation nach Anspruch 7, **dadurch gekennzeichnet, dass** das Mittel zum Inbetriebsregimebringen (E) durch steuerbare Ausgleichsventile (68, 90) der Durchflüsse an die Mischmittel (M) angeschlossen ist.

9. Installation nach einem der vorhergehenden Ansprüche, **dadurch gekennzeichnet, dass** mindestens ein Mischkopf (48, 50) mit einer Ausgleichskammer (52) verbunden ist.

10. Installation nach einem der Ansprüche 7 bis 9, **dadurch gekennzeichnet, dass** die steuerbaren Magnetventile (64, 66, 84, 85), die am Ausgang von jedem Mischkopf (48, 50) angeordnet sind, entgegengesetzt gesteuert werden.

11. Installation nach Anspruch 10, **dadurch gekennzeichnet, dass** jedes Paar von Magnetventilen, die dem Ausgang eines Mischkopfes zugeordnet sind, aus einem Elektromagnetschieber mit zwei Eingängen und zwei Ausgängen gebildet ist.

12. Installation nach einem der Ansprüche 4 bis 11, **dadurch gekennzeichnet, dass** sie eine zweite Steuerung aufweist, die dem zweiten Teil zugeordnet ist und die ein Mittel zum Erfassen von Informationen aufweist, die die Signale von mehreren Sensoren empfängt, darunter:
- mindestens einen Durchflusssensor (62, 86) und/oder einen Drucksensor (88) und/oder
- Sensoren von Zustandssignalen von mindestens einem der Magnetventile (58, 60, 80, 82, 64, 66, 84, 85) und der Ventile (68, 90) und der Mischköpfe (48, 50) sowie des Drucksensors (88) für die Kontrolle des Vakuumniveaus an dem Behälter (42) während der Bearbeitung;
- wobei die zweite Steuerung überdies ein Berechnungsmittel aufweist, das ein vorgespeichertes Einstellprogramm ausführt, und ein Einstellmittel, das von dem Berechnungsmittel gesteuert wird, das schließlich Steuerungssignale des Öffnungswerts von mindestens einem der Magnetventile (58, 60, 80, 82, 64, 66, 84, 85) zum Aufbringen von mindestens einer ersten und/oder zweiten Schicht anwendet.

13. Installation nach Anspruch 12, **dadurch gekennzeichnet, dass** die zweite Steuerung ein Steuerungsprogramm der Installation nach zwei aufeinanderfolgenden Modi ausführt, jeweils einem Start- oder Bereitschaftsmodus, in dem die Mischmittel (M1, M2) mit dem Mittel zum Inbetriebsregimebringen (E) verbunden sind, und dann einem Modus zum Aufbringen von Schichten, in dem sequentiell das Mischmittel (M1, M2) für jede Schicht, die auf den zu bearbeitenden Behälter aufzubringen ist, nacheinander mit der Ausgleichskammer (52) verbunden wird.

## Claims

1. Gas feed installation for a machine for depositing barrier layers on the internal wall of containers by means of a cold plasma, **characterized in that** it comprises:
- at least a first part comprising a tank (1) filled with a liquid component, which tank (1) is temperature-regulated and pressure-regulated in order to vaporize the liquid component so as to make it pass into the gas phase, which first part is connected via at least one gas line to the rest of the installation;
- at least a second part including a distribution device (M) which comprises at least one mixing head (48, 50) connected upstream to the gas lines (54, 56, 76, 78) that correspond to it via solenoid valves (58, 60, 80, 82) and connected downstream via a controlled solenoid valve (64, 84) to at least one injector (44) intended to be inserted into a container (42) to be treated, when the latter is placed in a vacuum chamber (40) ;
- a steady-flow means (E) which cooperates with the distribution device (M) so as to inject at least one gas mixture, and which is connected to the injector (44), each mixing head (48, 50) is connected to the steady-flow means (E) directly via a respective solenoid valve (66, 85) in parallel with respect to the injector (44).

2. Installation according to Claim 1, **characterized in that** each gas line connected to the tank (1) is controlled by a regulating flowmeter (21, 29) and **in that** the downstream outlets of the flowmeters (21, 29) are short-circuited on demand using controllable valves (17, 37) so as to rapidly bring the tank to the operating pressure.

3. Installation according to Claim 2, **characterized in that** the solenoid valves for short-circuiting the downstream outlets of the flowmeters (21, 29) are also connected to the tank (1) via a controllable steady-flow valve (17), so as to rapidly bring the tank to the operating pressure.

4. Installation according to any one of Claims 1 to 3, **characterized in that** it comprises feed operation state sensors and a first controller that includes a means for inputting information from at least one of the feed operation state sensors and the controller includes a means for executing a prerecorded control program on the basis of the input information and a means for producing, in response, control signals for regulating:
- the degree of opening of the flowmeters (21) and (29) ;
- the degree of opening of the steady-flow valves (17, 37) and/or a filling valve (7); and
- the heating energy supplied to the heater (11).

5. Installation according to Claim 4, **characterized in that** the feed operation state sensors consist of at least:
- a sensor (5) for measuring the liquid level in the tank (1) ;
- a pressure measurement sensor (39) for measuring the gas pressure in the tank (1);
- a thermocouple (25; 35) for regulating the temperature of at least one of the flowmeters (21; 29);
- a thermocouple (13) for measuring the temperature in the tank (1); and
- a safety thermocouple (15) for the temperature in the liquid part of the tank (1).

6. Installation according to Claim 5, **characterized in that** each flowmeter (21; 29) is associated with a respective thermocouple (25; 35) for regulating its temperature.

7. Installation according to Claim 1, **characterized in that** the steady-flow means (E) comprises a feeder (70) having a connector (72) that is connected to a vacuum pump.

8. Installation according to Claim 7, **characterized in that** the steady-flow means (E) is connected to the mixing means (M) via valves (68, 90) for balancing the controllable flow rates.

9. Installation according to any one of the preceding claims, **characterized in that** at least one mixing head (48, 50) is connected to a compensation chamber (52).

10. Installation according to any one of Claims 7 to 9, **characterized in that** the controllable solenoid valves (64, 66, 84, 85) placed at the outlet of each mixing head (48, 50) are controlled in opposition.

11. Installation according to Claim 10, **characterized in that** each pair of solenoid valves associated with the outlet of a mixing head is formed by a slide solenoid valve having two inlets and two outlets.

12. Installation according to any one of Claims 4 to 11, **characterized in that** it includes a second controller associated with the second part and which includes an information inputting means, which receives the signals from a plurality of sensors, among which are:
- at least one flow rate sensor (62, 86) and/or at least one pressure sensor (88); and/or
- sensors for picking up signals corresponding to the state of at least one of the solenoid valves (58, 60, 80, 82, 64, 66, 84, 85) and of the valves (68, 90) and of the mixing heads (48, 50), as well as that of the pressure sensor (88) for controlling the vacuum level in the container (42) during treatment;
- the second controller moreover including a computer means which executes a prerecorded regulating program and a regulating means controlled by the computer means that finally applies signals for controlling the degree of opening of at least one of the solenoid valves (58, 60, 80, 82, 64, 66, 84, 85) for applying at least a first and/or a second layer.

13. Installation according to Claim 12, **characterized in that** the second controller executes a program for controlling the installation in two successive modes, namely a startup or standby mode, in which the mixing means (M1, M2) are connected to the steady-flow means (E), and then a layer deposition mode, in which, sequentially, the mixing means (M1, M2) for each layer to be deposited on the container to be treated is connected in succession to the compensation chamber (52), respectively.
